# EUROPEAN PATENT APPLICATION

(11) **EP 2 738 288 A1**
(43) Date of publication of application: **04.06.2014**
(21) Application number: 12820626.5
(22) Date of filing: 25.07.2012
(51) Int. Cl.: C23C 16/458, C23C 16/509

(54) **PLASMA CVD DEVICE**

(30) Priority: 29.07.2011 JP 2011166919
(71) Applicant: Kabushiki Kaisha Kobe Seiko Sho, Chuo-ku, Kobe-shi, Hyogo 651-8585 (JP)
(72) Inventor: TAMAGAKI, Hiroshi, Hyogo 676-8670 (JP); HAGA, Junji, Hyogo 676-8670 (JP)
(74) Representative: TBK
(86) International application number: PCT/JP2012/004733
(87) International publication number: WO 2013/018319

(57) **Abstract**

A plasma CVD apparatus of the present invention includes: a vacuum chamber; a vacuum exhaust unit that evacuates the vacuum chamber so that the inside becomes a vacuum state; a gas supply unit that supplies a source gas into the vacuum chamber; a plasma generation power supply that generates plasma in the source gas supplied into the vacuum chamber; a plurality of rotation holding units that hold the substrates in a spinning state; and a plurality of revolution mechanisms that revolve the plurality of rotation holding units around a revolution axis parallel to a shaft center and rotation axes of the rotation holding units, wherein the respective revolution mechanisms are divided as any one of a first group connected to one electrode of the plasma generation power supply and a second group connected to the other electrode of the plasma generation power supply.

## Description

### TECHNICAL FIELD

The present invention relates to a plasma CVD apparatus that deposits a CVD coating on a substrate.

### BACKGROUND ART

Automotive engine parts such as a piston ring are required to have satisfactory wear resistance, thermal resistance, seizure resistance, and the like. For this reason, a wear-resistant coating such as DLC (Diamond-Like-Carbon) is deposited on these mechanical parts by using a plasma CVD method.

When depositing a coating on the above-described substrates by the plasma CVD method, it is desirable that a coating process be simultaneously performed on a lot of substrates loaded in a vacuum chamber from the viewpoint of productivity. Therefore, when the coating process is performed on the plural substrates at one time, the coatings deposited on the respective substrates are required to have uniform thickness and quality. For this reason, an existing plasma CVD apparatus performs a coating process while respective substrates disposed on a table are revolved in a spinning state.

For example, Patent Document 1 discloses a coating apparatus that includes a plasma generation unit, a multicusped magnetic field generation unit, and a holding and rotating unit. The plasma generation unit generates plasma inside a vacuum chamber in which a substrate to be deposited is disposed. The multicusped magnetic field generation unit generates a multicusped magnetic field that confines the plasma generated by the plasma generation unit inside a space (a confinement space) near the substrates. The holding and rotating unit holds the substrate and rotates the substrate about the vicinity of the center of the confinement space as the center axis. In the coating apparatus, all substrates are connected to one electrode of the power supply through the table on which the substrates are placed, so that a bias voltage is applied thereto. These substrates generate a glow discharge by using the vacuum chamber of a ground potential that is connected to the other electrode of the power supply and serves as a counter electrode, so that plasma is generated. Then, a source gas is decomposed by the plasma, so that a coating is deposited on the surfaces of the substrates.

Incidentally, in a case where the coating deposited by the plasma CVD method is an insulation coating such as DLC, the conductivity of the surface of the substrate gradually disappears by the coating deposited on the surface of the substrate when the coating thickness increases as the coating process is performed. However, since the substrate is replaced by new substrate having a conductive surface when the coating process ends, there is no need to worry about the case in which the conductivity of the surface of the substrate completely disappears as the coating is continuously deposited.

For example, in the coating apparatus disclosed in Patent Document 1, the coating is also deposited on a portion other than the substrate as the coating subject, that is, the inner wall of the vacuum chamber. The inner wall of the vacuum chamber is not replaced every time like the substrate. For this reason, the insulation coating deposited on the vacuum chamber becomes thick as the coating processes continue. Therefore, the electrical resistance of the inner wall of the vacuum chamber increases with an increase in the coating thickness of the deposited coating. Accordingly, the plasma that is generated by using the inner wall as one electrode becomes unstable or the process conditions stray from the optimal condition.

In order to solve such problems, the present inventors have proposed the following apparatus.

This apparatus is a plasma CVD apparatus that deposits a coating on a substrate (generally indicates a coating subject and a holder supporting the coating subject) revolving in a spinning state by the use of a plasma CVD method. In the plasma CVD apparatus, plural spinning axes of a spinning and revolving table are divided as two groups, and the respective spinning axes of the respective groups are electrically insulated from one another and are insulated from the chamber and the spinning axes of the other group. Then, the spinning axes of one group are connected to one electrode of a plasma generation power supply, and the spinning axes of the other group are connected to the other electrode (the electrode having polarity opposite to that of the one electrode) of the plasma generation power supply. In this state, when power is applied to the spinning axes of the respective groups and a plasma generation gas is supplied into a vacuum chamber, discharge plasma is generated between the spinning axes of the respective groups, so that a coating is deposited on substrates.

In this apparatus, the number of substrate groups mounted on the two groups of spinning axes is substantially the same. Then, the substrate groups of the respective groups generate plasma while serving as both electrodes of the AC power supply, and deposit a coating according to the plasma CVD method. The substrates are mounted on the spinning and revolving tables. For this reason, this apparatus may perform a highly uniform process. The components involved with the supply of power for generating plasma are the substrates and the holders. For this reason, even when a coating is deposited on the other portion such as the chamber so that an insulation surface is formed on the other portion, the plasma generation state is not influenced. As a result, it is possible to stably deposit a coating for a long period of time and to reduce maintenance works such as a chamber cleaning operation when the coating operations are repeated.

However, in this apparatus, one spinning and revolving table needs to be equipped with the spinning axes having different potentials, and hence a problem arises in that the structure of the spinning and revolving table becomes complicated.

### CITATION LIST

### PATENT DOCUMENT

Patent Document 1: JP 2007-308758 A

### SUMMARY OF THE INVENTION

An object of the present invention is to provide a plasma CVD apparatus capable of performing a coating process in a stable coating condition even when the plasma CVD apparatus is used for a long period of time while depositing a uniform coating on plural substrates at one time, preventing a CVD coating from being easily deposited on a portion other than the substrate, preventing a frequent cleaning operation, providing satisfactory convenience in use, and preventing a complicated structure.

According to an aspect of the present invention, there is provided a plasma CVD apparatus that deposits a coating on each of a plurality of substrates as coating subjects, the plasma CVD apparatus including: a vacuum chamber; a vacuum exhaust unit that evacuates the vacuum chamber so that the inside becomes a vacuum state; a gas supply unit that supplies a source gas into the vacuum chamber; a plasma generation power supply that generates plasma in the source gas supplied into the vacuum chamber; a plurality of rotation holding units that hold the substrates in a spinning state; and a plurality of revolution mechanisms that revolve the plurality of rotation holding units around a revolution axis parallel to rotation axes of the rotation holding units, wherein the respective revolution mechanisms are divided into any one of a first group connected to one electrode of the plasma generation power supply and a second group connected to the other electrode of the plasma generation power supply.

### BRIEF DESCRIPTION OF DRAWINGS

[Fig. 1] Fig. 1 is a perspective view illustrating a plasma CVD apparatus according to a first embodiment.
[Fig. 2] Fig. 2 is a top view illustrating the plasma CVD apparatus according to the first embodiment.
[Fig. 3] Fig. 3 is a diagram illustrating an example in which a substrate is installed in a rotation holding unit.
[Fig. 4] Fig. 4 is a perspective view illustrating a plasma CVD apparatus according to a second embodiment.
[Fig. 5] Fig. 5 is a top view illustrating the plasma CVD apparatus according to the second embodiment.

### DESCRIPTION OF EMBODIMENTS

Hereinafter, embodiments of a plasma CVD apparatus according to the present invention will be described in detail with reference to the drawings. Furthermore, in the description below, the same reference numerals will be given to the same components even in the different embodiments. Such components have the same name and the same function. Accordingly, the detailed description of the components will not be repeated.

### <First Embodiment>

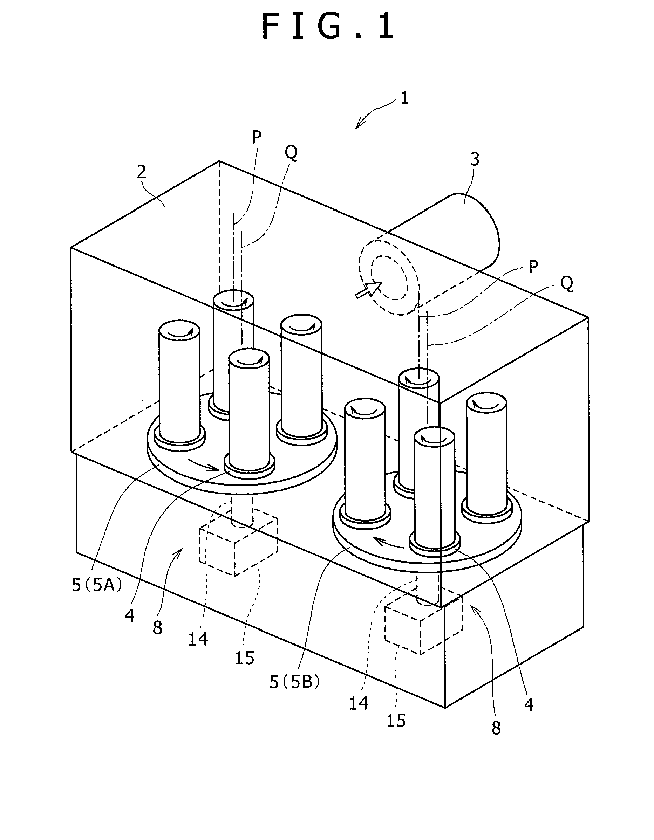

Fig. 1 illustrates an overall configuration of a plasma CVD apparatus 1 of a first embodiment.

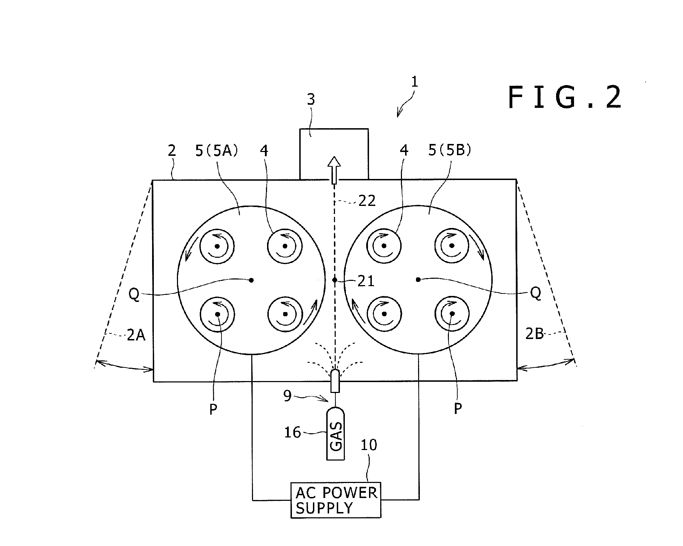

The plasma CVD apparatus 1 includes a vacuum chamber 2, a vacuum exhaust unit 3, and plural (eight in this embodiment) rotation holding units 4. Each rotation holding unit 4 spins while holding a substrate W as a coating subject. These plural rotation holding units 4 are arranged on revolution tables 5. The plasma CVD apparatus 1 is equipped with revolution mechanisms 8. The respective revolution mechanisms 8 revolve the revolution tables 5 having the plural rotation holding units 4 installed thereon about the revolution axis Q parallel to the rotation axis (the spinning axis P) of each rotation holding unit 4. Then, in the plasma CVD apparatus 1, the plural (two in this embodiment) revolution tables 5 are disposed so as to be symmetrical with respect to a center line 21 of the plasma CVD apparatus 1 (the vacuum chamber 2) (bilaterally symmetric to each other with a perpendicular imaginary plane 22 passing through the center line 21 in Fig. 2 interposed therebetween).

Further, the vacuum exhaust unit 3 is installed on the center line 21 (the imaginary plane 22 in this embodiment). Here, the number of the revolution tables 5 is not particularly limited as long as the revolution tables are disposed so as to be symmetrical with respect to the center line 21 of the plasma CVD apparatus 1. Further, the number of the rotation holding units 4 disposed in each revolution table 5 is not particularly limited, but it is desirable that the number be the same as the number of the revolution tables 5. Further, in each revolution table 5, the plural rotation holding units 4 are arranged at the same interval about the revolution axis with the same radius from the revolution axis Q of the revolution table 5. That is, the plural rotation holding units 4 are arranged in parallel at the same interval in the circumferential direction about the revolution axis Q of the revolution table 5.

Furthermore, in the present invention, the "state where the substrate W spins" indicates a state where the substrate W rotates (spins) about the spinning axis P penetrating the substrate W. Further, the "state where the substrate W revolves" indicates a state where the substrate W rotates about the revolution axis Q separated therefrom, that is, the substrate W moves around the revolution axis Q. Further, the spin direction and the revolution direction of the substrate W are set as illustrated in Figs. 1 and 2. That is, the spin direction and the revolution direction of the substrate W are set so as to be symmetrical with respect to the center line 21 (the imaginary plane 22 in this embodiment) of the plasma CVD apparatus 1. However, this is an example, and the directions are not limited the spin direction and the revolution direction (illustrated in the drawings).

Further, as illustrated in Fig. 2, the plasma CVD apparatus 1 includes a gas supply unit 9 and a plasma generation power supply 10, and deposits a coating on the plural substrates W held by the rotation holding units 4 by using a plasma CVD method. The gas supply unit 9 supplies a source gas into the vacuum chamber 2. The plasma generation power supply 10 generates plasma in the process gas supplied into the vacuum chamber 2.

The configuration of the plasma CVD apparatus 1 will be described in more detail.

The vacuum chamber 2 includes an inner space that has a symmetrical shape in the horizontal direction (the right and left direction in Fig. 2) about the predetermined center line 21 extending in the up to down direction. The vacuum chamber 2 of this embodiment includes an inner space having a symmetrical shape in a direction perpendicular to the imaginary plane 22 with the perpendicular imaginary plane 22 interposed therebetween. More specifically, the vacuum chamber 2 includes an inner space that has a symmetrical rectangular parallelepiped shape in the perpendicular direction with the imaginary plane 22 interposed therebetween. The vacuum chamber 2 is a casing that is formed to air-tightly seal the inside (the inner space) with respect to the outside. The vacuum pump (the vacuum exhaust unit) 3 is installed at the side portion of the vacuum chamber 2 (specifically, the peripheral wall perpendicular to the imaginary plane 22). The vacuum pump 3 evacuates the vacuum chamber 2 so as to cause the inside of the vacuum chamber 2 to become a low-pressure state (a vacuum state or a substantially vacuum state). The vacuum pump 3 may decrease the pressure inside the vacuum chamber 2 to a vacuum state (or a substantially vacuum state). Then, the plural substrates W are accommodated inside the vacuum chamber 2 while being respectively held by the rotation holding units 4.

The substrates W that are subjected to a coating process in the plasma CVD apparatus 1 of the first embodiment are disposed in a cylindrical space, which is long in the up to down direction, in order to perform a uniform coating process thereon.

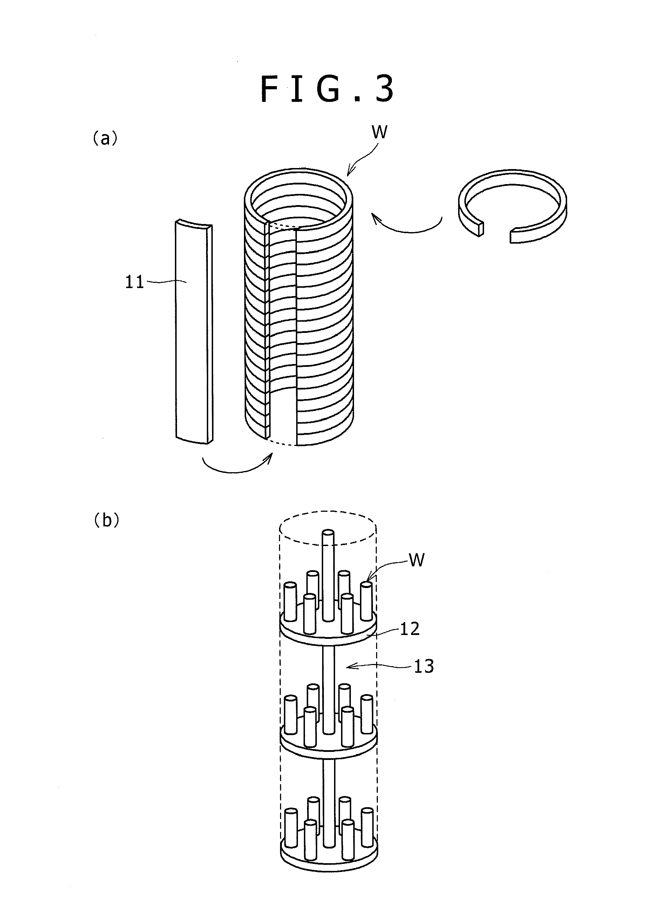

For example, in a case where the substrate W is a piston ring illustrated in Fig. 3(a), even when the substrates are directly stacked, the stacked substrates may not form a perfect cylindrical shape since a part of the stacked substrates in the circumferential direction lack, and hence there is a possibility that the coating process may not be uniformly performed. As in the case of Fig. 3(a), when the perfect cylindrical shape is not formed since a part of the stacked substrates in the circumferential direction lack, the uniform coating process may be performed on the substrates by covering the opened portions using a cover 11.

Further, in a case where the substrate W to be coated is a small member (for example, a small piston pin) as illustrated in Fig. 3(b), an installation jig 13 is prepared so that plural disks 12 are stacked in plural stages with a gap therebetween in the up to down direction, and the respective substrates W are disposed on the respective disks 12. The installation jig 13 is formed so as to be positioned inside the above-described cylindrical space.

Further, in a case where the substrate W is a material other than the above-described material, the installation jig is appropriately manufactured so that the installation jig and the substrates W are positioned inside the cylindrical space.

The rotation holding unit 4 is, for example, is a circular placement table of which the upper surface is horizontal. The rotation holding unit 4 is rotatable about the rotation axis (the spinning axis P) extending in the up to down direction. Accordingly, the rotation holding unit 4 rotates the substrate W that is disposed on the upper surface thereof or is disposed above the rotation holding unit 4 about the rotation axis (the spinning axis P). The rotation holding unit 4 is formed so that a voltage may be supplied thereto, and the voltage supplied thereto is applied to each substrate W through the rotation holding unit 4. In this embodiment, the same voltage is supplied to four rotation holding units 4 disposed on one revolution table 5.

In the case of the plasma CVD apparatus 1 illustrated in Fig. 1, four rotation holding units 4 are disposed on one revolution table 5. These four rotation holding units 4 are disposed on the revolution table 5 so that the rotation holding units are arranged in parallel on one circle in the top view and the cylindrical shape is uprightly formed on the upper surface of the revolution table 5.

The center axis (the revolution axis Q) of the revolution table 5 extends in the up to down direction. Then, the revolution table 5 rotates about the revolution axis Q. As described above, the plural (four) rotation holding units 4 are arranged in parallel with a gap therebetween in the circumferential direction about the revolution axis Q on the upper surface of the revolution table 5. Specifically, the plural rotation holding units 4 are disposed on the upper surface of the revolution table 5 so as to be arranged in parallel at the same interval about the revolution axis Q (in the circumferential direction) with the same distance (radius) from the revolution axis Q of the revolution table 5. A rotational driving unit 15 that rotates the revolution table 5 about the revolution axis Q is installed at the lower side of the revolution table 5.

Specifically, the revolution mechanism 8 includes the revolution table 5, a shaft portion 14, and the rotational driving unit 15. The shaft portion 14 extends downward along the revolution axis Q from the lower surface of the revolution table 5. The rotational driving unit 15 rotationally drives the shaft portion 14. When such a rotational driving unit 15 rotates the revolution table 5 about the revolution axis Q through the shaft portion 14, the rotation holding unit 4 holding the substrate W rotates (revolves) about the revolution axis Q. Since the rotation holding unit 4 rotates about the shaft center (the spinning axis P) along with the revolution, the substrate W held by the rotation holding unit 4 spins. That is, the substrate W held by the rotation holding unit 4 rotates about the spinning axis P along with the rotation holding unit 4. The plasma CVD apparatus 1 of this embodiment is equipped with two revolution tables 5, that is, two revolution mechanisms 8.

By such a mechanism, a coating is deposited on the substrates W inside the vacuum chamber 2 in a manner such that the substrates rotate (revolve in a spinning state) along with the rotation holding unit 4 about the revolution axis Q by the revolution table 5 while the substrates rotate about the spinning axes P by the respective rotation holding units 4.

Furthermore, the substrates W that are held by the adjacent rotation holding units 4 are installed so as not to cause any mechanical interference therebetween while the rotation holding units revolve in the spinning state by considering the rotation phase and adjusting the sizes of the substrates W. Further, the revolution table 5A and the revolution table 5B are also appropriately installed so as not to cause any mechanical interference in a revolution state.

As illustrated in Fig. 2, the gas supply unit 9 is installed in the vacuum chamber 2. The gas supply unit 9 supplies a process gas containing a source gas into the vacuum chamber 2. The gas supply unit 9 includes a cylinder 16, and supplies a source gas necessary for depositing the CVD coating and an assist gas assisting the coating process by a predetermined amount from the cylinder 16 into the vacuum chamber 2. Furthermore, the gas supply unit 9 is disposed so as to be symmetrical with respect to the center line 21 (the imaginary plane 22) of the plasma CVD apparatus 1. That is, when one gas supply unit 9 is provided, the gas supply unit is disposed so that the center of the gas supply unit 9 matches the center line 21 (the imaginary plane 22) of the plasma CVD apparatus 1. Further, when two gas supply units 9 are provided, the respective gas supply units 9 are disposed so that the center position between these two gas supply units 9 matches the center line 21 (the imaginary plane 22) of the plasma CVD apparatus 1. When the gas supply units 9 are disposed in this way, the gas is uniformly discharged to the substrates W disposed on the two revolution tables 5.

In a case where a carbon-based CVD coating such as DLC (Diamond-Like Carbon and amorphous carbon coating) is deposited in the plasma CVD apparatus 1, the process gas is formed by adding an inert gas (argon, helium, or the like) as an assist gas to a source gas containing, for example, hydrocarbon (acethylene, ethylene, methane, ethane, benzene, toluene, or the like). Further, in a case where a CVD coating (SiOx coating, SiOC coating, SiNx coating, or SiCN coating) is deposited by a silicon compound in the plasma CVD apparatus 1, the process gas is formed by adding a reactive gas such as oxygen and an inert gas such as argon as an assist gas to, for example, a source gas containing a silicon-based organic compound (monosilane, TMS, TEOS, HMDSO, or the like) or silicon such as silane. Furthermore, the plasma CVD apparatus 1 may deposit a TiOx coating, an AlOx coating, an AlN coating, or the like as the CVD coating other than the above-described coating.

Further, a small amount of addition source gas may be mixed with a main source gas. For example, a Si-containing DLC is deposited by adding a small amount of a silicon-based organic compound gas to hydrocarbon as a main source gas when depositing a DLC coating. Alternatively, a metal-containing DLC (for example, DLC with a small amount of titanium) is deposited by adding a small amount of a source gas (for example, TTiP (Titanium isopropoxide) or TDMAT (Tetradimethylaminotitanium) to hydrocarbon as a main source gas when depositing the DLC coating.

Furthermore, the source gas, the reactive gas, and the assist gas may be obtained by appropriately combining various gases.

Further, different coating supply sources (sputtering sources, AIP evaporation sources, or the like) may be installed inside the vacuum chamber 2. In this case, the coating supply sources are disposed so as to be symmetrical with respect to the center line 21 (the imaginary plane 22) of the vacuum chamber 2. That is, when one coating supply source is provided, the coating supply source is disposed so that the center of the coating supply source matches the center line 21 (the imaginary plane 22). Further, when two coating supply sources are provided, the coating supply sources are disposed so that the center position between these two coating supply sources matches the center line 21 (the imaginary plane 22) of the vacuum chamber 2. When the coating supply sources are disposed in this way, the coating is uniformly deposited on the substrates W disposed on the two revolution tables 5.

The plasma generation power supply 10 that is provided in the plasma CVD apparatus 1 of this embodiment generates plasma by causing a glow discharge while the process gas is supplied into the vacuum chamber 2. The plasma generation power supply 10 of this embodiment supplies AC power. The power supplied from the plasma generation power supply 10 may be AC power of which positive and negative states of a current or a voltage change in response to a waveform of a sine wave or AC power of a rectangular wave of which positive and negative states change in response to a pulsed waveform. Further, AC power in which a pulse group having the same continuous polarity alternately appears or AC power in which a rectangular wave is superimposed on AC power of a sine wave may be used as the AC power. Furthermore, there is a case in which the waveform of the AC power (the AC voltage in this embodiment) in the actual plasma generation state may be strained due to the influence of the generation of the plasma. Further, when the plasma is generated, the zero level of the AC voltage is shifted. For this reason, when the potential of each electrode with respect to the ground potential is measured, it is observed that 80 to 95% of the application voltage is applied to the negative electrode and 5 to 20% of the application voltage is applied to the positive electrode. The plasma generation power supply 10 may be configured as one AC power supply as described above, but may be configured as, for example, two power supplies that realize a change in potential as that of the one AC power supply.

The frequency of the AC power supplied from the plasma generation power supply 10 is desirably 1 kHz to 1 MHz. When the frequency of the AC power is smaller than 1 kHz, the charge-up of the coating easily occurs. Further, when the frequency of the AC power exceeds 1 MHz, it is difficult to realize a mechanism that transmits power (the AC voltage in this embodiment) to the substrate W held by the rotation holding unit 4 which revolves in a spinning state. Further, it is more desirable that the frequency of the AC power be in the range of 10 kHz to 400 kHz in consideration of the availability and the like of the power supply. Further, the AC power (the AC voltage in this embodiment) supplied from the plasma generation power supply 10 is desirably 300 to 3000 V necessary for keeping the glow discharge in the peak value of the voltage. Further, the AC power supplied from the plasma generation power supply 10 changes by the surface area of the substrate W, but may have power density of about 0.05 to 5 W/cm² in the power per unit area.

When the AC power having the frequency, the voltage, and the power density is supplied between a pair of electrodes disposed inside the vacuum chamber 2, the glow discharge is generated between the electrodes. Then, when the process gas supplied into the vacuum chamber 2 is decomposed by the generated glow discharge, plasma is generated. Subsequently, a gas element such as a source gas decomposed by the plasma is deposited on the surface of the electrode, so that a CVD coating is deposited thereon. That is, when the substrate W is used for any one of the pair of electrodes, the CVD coating is deposited on the surface of the substrate W.

Furthermore, heating heaters may be appropriately disposed inside the vacuum chamber 2. The heating heaters adjust the quality of the coating deposited on the substrate W by controlling the temperature of the substrate W. In this case, the heating heaters are disposed so as to be symmetrical with respect to the center line 21 (the imaginary plane 22) of the vacuum chamber 2. That is, when one heating heater is provided, the heating heater is disposed so that the heating center of the heating heater matches the center line 21 (the imaginary plane 22) of the vacuum chamber 2. Further, when two heating heaters are provided, the heating heaters are disposed so that the center position between these two heating heaters matches the center line 21 (the imaginary plane 22) of the vacuum chamber 2. When the heating heaters are disposed in this way, the coating is uniformly deposited on the substrates W disposed on the two revolution tables 5.

As illustrated in Fig. 2, in the plasma CVD apparatus 1 of this embodiment, the revolution table 5A that is connected to one electrode of the plasma generation power supply 10 is set as a revolution table belonging to a first group. Further, the revolution table 5B that is connected to the other electrode (the electrode having polarity opposite to that of the one electrode) of the plasma generation power supply 10 is set as a revolution table belonging to a second group.

One revolution table 5 (the revolution table 5A illustrated in the drawings) is connected to one electrode of the plasma generation power supply 10, and the other revolution table 5 (the revolution table 5B illustrated in the drawings) is connected to the other electrode (the electrode having polarity opposite to that of the one electrode) of the plasma generation power supply 10. Accordingly, plasma is generated between the substrate W that is held by the rotation holding unit 4 disposed on the revolution table (the revolution table connected to the one electrode of the plasma generation power supply 10) 5 belonging to the first group and the substrate W that is held by the rotation holding unit 4 disposed on the revolution table (the revolution table connected to the other electrode of the plasma generation power supply 10) 5 belonging to the second group having polarity opposite to that of the first group. Furthermore, as for the groups described herein, one revolution table 5 belongs to each of the first group and the second group of this embodiment, but two or more revolution tables 5 may belong to each of the groups. However, as described above, since plural revolution tables 5 need to be disposed so as to be symmetrical with respect to the center line 21 (the imaginary plane 22) of the plasma CVD apparatus 1, the number of the revolution tables 5A belonging to the first group is equal to the number of the revolution tables 5B belonging to the second group. Of course, the total number of the revolution tables 5 (the sum of the number of the revolution tables 5A belonging to the first group and the number of the revolution tables 5B belonging to the second group) becomes an even number.

The four rotation holding units 4 disposed on the revolution table 5A belonging to the first group are all connected to one electrode of the plasma generation power supply 10. Further, the four rotation holding units 4 disposed on the revolution table 5B belonging to the second group are all connected to the other electrode (the electrode having polarity opposite to that of the one electrode) of the plasma generation power supply 10. That is, each rotation holding unit 4 on the revolution table 5A belonging to the first group and each rotation holding unit 4 on the revolution table 5B belonging to the second group normally have opposite polarities during the application of the voltage.

Furthermore, the respective revolution tables 5 are provided with brush mechanisms (not illustrated), and the voltages of respective polarities are applied to the respective rotation holding units 4 through the brush mechanisms. The revolution tables 5 are held in the vacuum chamber 2 so as to be rotatable through bearing mechanisms, but the voltage may be applied to the revolution tables 5 through the bearing mechanisms. Similarly, the respective rotation holding units 4 are rotatably held by the revolution tables 5 through the bearing mechanisms, but the voltage may be applied to the rotation holding units 4 through the bearing mechanisms.

Subsequently, a CVD coating method using the plasma CVD apparatus 1 will be described.

First, as illustrated in Figs. 1 and 2, in the plasma CVD apparatus 1 of this embodiment, four rotation holding units 4 are disposed along four axes at the same interval (every 90°) in the circumferential direction about the revolution axis Q on the revolution table 5 disposed inside the vacuum chamber 2. A CVD coating is deposited by the plasma CVD apparatus 1.

First, the substrates W are set on the rotation holding units 4. The substrates W may be placed and fixed onto the rotation holding units 4 or may be placed on the rotation holding units 4 by the installation jigs 13. Furthermore, the vacuum chamber 2 of the plasma CVD apparatus 1 of this embodiment is equipped with a door 2A for the revolution table 5A belonging to the first group and a door 2B for the revolution table 5B belonging to the second group that are provided at the bilaterally symmetric positions with the center line 21 (the imaginary plane 22) interposed therebetween. Then, the door 2A and the door 2B are opened, and the substrates W are placed on the respective revolution tables 5A and 5B inside the vacuum chamber 2.

When the substrate W is prepared in this way, the vacuum pump 3 (the vacuum exhaust unit 3) evacuates the vacuum chamber 2 until the inside becomes a high-vacuum state.

Next, if necessary, a glow discharge for a surface cleaning may be generated between the substrates W, by supplying an inert gas such as Ar and/or a gas such as H₂ or O₂ from the gas supply unit 9 into the vacuum chamber 2 and applying the power from the plasma generation power supply 10 (an ion bombardment process). Further, the above-described heating heaters may perform a pre-heating process on the substrates W held by the rotation holding units 4 that revolve in a spinning state. Further, in a case where different coating supply sources (sputtering sources, AIP evaporation sources, and the like) are installed inside the vacuum chamber 2, an intermediate layer may be formed between the substrate W and the coating deposited by the plasma CVD apparatus by using these coating supply sources.

Then, the gas supply unit 9 supplies a process gas into the vacuum chamber 2, so that the pressure inside the vacuum chamber 2 is kept at the pressure of 0.1 to 1000 Pa suitable for the coating process.

As for the coating process, the plasma generation power supply 10 supplies AC power. Accordingly, a glow discharge is generated between the substrate W that is held by the rotation holding unit 4 disposed on the revolution table 5A belonging to the first group and the substrate W that is held by the rotation holding unit 4 disposed on the revolution table 5B belonging to the second group, so that plasma necessary for the coating process is generated between the substrates W.

The pressure value suitable for the coating process is different depending on the type of the CVD coating (the process gas and the reactive gas). In this embodiment, a pressure of about 0.1 Pa to 1000 Pa is desirable. As described above, a stable glow discharge is generated when the pressure inside the vacuum chamber 2 is about 0.1 Pa to 1000 Pa, so that the coating process is performed at a satisfactory coating speed. Furthermore, it is desirable that the coating pressure be 100 Pa or less from the viewpoint of suppressing the production of powder accompanied by the reaction in the gas.

Further, the voltage of the AC power supplied from the plasma generation power supply 10 is desirably between 300 V to 3000 V (the peak value of the voltages across both electrodes) necessary for keeping the glow discharge. Furthermore, the AC power (the AC voltage in this embodiment) supplied from the plasma generation power supply 10 is desirably about 0.05 to 5 W/cm² per unit area of the substrate W.

In this way, the AC voltage and the AC power supplied from the plasma generation power supply 10 are adjusted, and then the substrates W of the respective rotation holding units 4 revolve in a spinning state. Accordingly, a glow discharge is generated between the substrates W disposed on the different revolution tables 5, so that a CVD coating having a uniform thickness is deposited on the surfaces of the substrates W.

When ending the coating process, the coating process ends by stopping the output of the plasma generation power supply 10 and the introduction of the process gas. When the temperature of the substrate W is high, some time is spent until the temperature of the substrate W decreases if necessary. Subsequently, the inside of the vacuum chamber 2 is opened to the atmosphere, and the substrate W is separated from the rotation holding unit 4. In this way, the substrate W having the CVD coating deposited on the surface thereof may be obtained.

As described above, since the plasma CVD apparatus 1 is equipped with the revolution table 5A and the revolution table 5B having opposite polarities, a difference in potential inevitably occurs between the substrates W held by the rotation holding units 4 disposed on the adjacent revolution tables 5A and 5B. Accordingly, a glow discharge is reliably generated between the substrates. Then, when the positive and negative states of the power supplied from the plasma generation power supply 10 change, the polarities of the rotation holding units 4 of the respective revolution tables 5A and 5B also change, and hence the glow discharge is continuously generated between both revolution tables. Accordingly, the plasma CVD apparatus 1 performs a uniform coating process on the plural substrates W at one time.

That is, when the CVD coating is deposited on the substrate W by causing the substrate W held by the rotation holding unit 4 disposed on the revolution table 5A belonging to the first group to serve as a working electrode, the substrate W that is held by the rotation holding unit 4 disposed on the revolution table 5B belonging to the second group becomes a counter electrode (an opposite electrode). Then, when the positive and negative states of the power supplied from the plasma generation power supply 10 change, the working electrode and the counter electrode change. That is, the substrate W that is held by the rotation holding unit 4 disposed on the revolution table 5B belonging to the second group becomes the working electrode, and the substrate W that is held by the rotation holding unit 4 disposed on the revolution table 5A belonging to the first group becomes the counter electrode.

With the above-described configuration, the substrates W become the counter electrodes for generating the glow discharge, but the casing such as the vacuum chamber 2 and the revolution table 5 do not become the counter electrodes for generating the glow discharge. That is, the components such as the revolution table 5 and the vacuum chamber 2 do not serve as the electrodes for generating the glow discharge generating the plasma. Accordingly, even when the plasma CVD apparatus 1 is operated for a long period of time so that an insulation coating is thickly deposited on the components such as the substrate holding portion 20 and the vacuum chamber 2, the plasma does not become unstable. As a result, the plasma CVD apparatus 1 may stably deposit the CVD coating without non-uniform quality or thickness. Further, since the components such as the revolution table 5 and the vacuum chamber do not serve as the electrodes for generating the glow discharge, the components are not exposed to the plasma that decomposes the source gas. For this reason, the coating is not easily deposited on these components (the revolution table 5, the vacuum chamber 2, and the like) compared to the existing coating apparatus. As a result, flakes causing the thick deposition of the coating are hardly scattered, and a coating defect is not also easily generated. The coating represented as the metal-containing DLC exhibits slight conductivity. However, even in this case, the coating is not easily deposited on the casing such as the vacuum chamber 2. For this reason, the scattering of the flakes hardly occurs and the coating defect hardly occurs. Further, even when a coating having some conductivity like the metal-containing DLC is deposited on the substrate W, an insulation coating with poor coating quality may be deposited on a chamber portion where the plasma is weak. In such a case, the effect of preventing the unstable plasma is exhibited.

In this embodiment, two revolution tables 5 are disposed in one plasma CVD apparatus 1. However, the total number of the revolution tables 5 of the plasma CVD apparatus 1 is not limited to two. For example, the total number of the revolution tables 5 may be four, six, eight, or the like instead of two. Further, the total number of the revolution tables 5 may be ten or more. In any case, the revolution tables 5 are disposed inside the vacuum chamber 2 so as to be symmetrical with respect to the center line of the vacuum chamber 2. Accordingly, the total number of the revolution tables 5 is limited to an even number.

The plural (even number of) revolution tables 5 may be divided as the revolution table 5A that belongs to the first group connected to one electrode of the plasma generation power supply 10 and the revolution table 5B that belongs to the second group connected to the other electrode (the electrode having polarity opposite to that of the one electrode) of the plasma generation power supply 10. The number of the rotation holding units 4 disposed on the respective revolution tables 5 is the same. Then, the revolution table 5A belonging to the first group and the revolution table 5B belonging to the second group are lined up at every second position (alternately) so as to be symmetrical with respect to the center line of the plasma CVD apparatus 1. Accordingly, plasma is generated between the substrates W disposed on the revolution table 5A belonging to the first group and the revolution table 5B belonging to the second group adjacent to the first group, and hence a CVD coating is deposited on the respective substrates W held by the rotation holding units 4 at a stable condition.

Further, in the plasma CVD apparatus 1 of this embodiment, a voltage of the same potential is supplied to the respective substrates W on one revolution table 5. For this reason, it is possible to simplify the structure (the voltage supply structure) of the plasma CVD apparatus 1 compared to, for example, a case where a voltage of a different potential is supplied to the respective substrates W in one revolution table 5. That is, the plasma CVD apparatus 1 may simplify the structure compared to a case where plural rotation holding units 4 having different potentials are installed in one revolution table 5.

### <Second Embodiment>

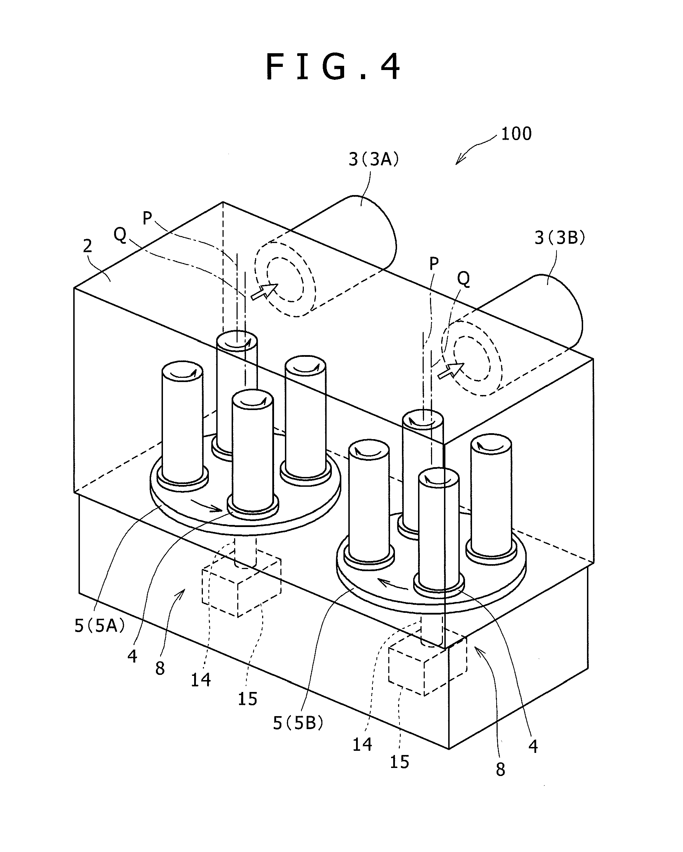

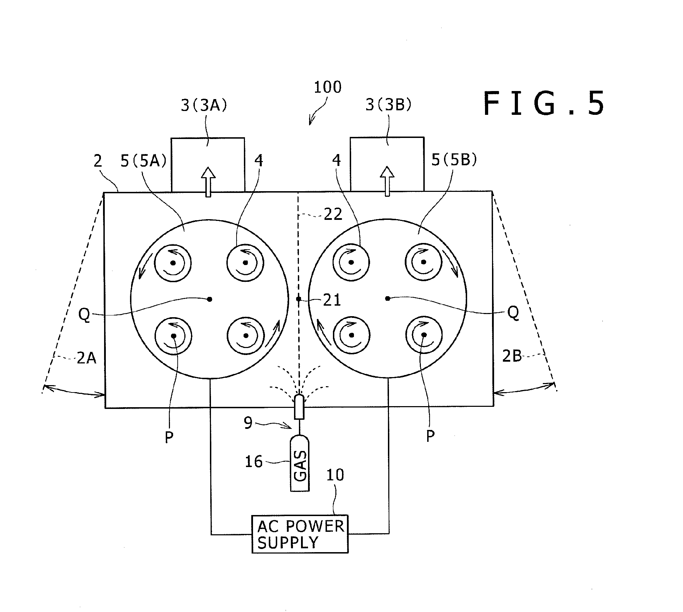

Figs. 4 and 5 illustrate a plasma CVD apparatus 100 of a second embodiment.

The plasma CVD apparatus 100 is different from the plasma CVD apparatus 1 of the first embodiment in the following points. The plasma CVD apparatus 100 includes two vacuum exhaust units 3 and 3 that evacuate the vacuum chamber 2 so that the inside becomes a vacuum state. These two vacuum exhaust units 3 and 3 are installed in the vacuum chamber 2 so as to correspond to the revolution table 5A belonging to the first group and the revolution table 5B belonging to the second group. That is, the vacuum exhaust unit (the vacuum pump) 3A corresponding to the revolution table 5A belonging to the first group and the vacuum exhaust unit (the vacuum pump) 3B corresponding to the revolution table 5B belonging to the second group are disposed on the rear side wall of the vacuum chamber 2.

Then, as in the first embodiment, the gas supply unit 9 is disposed between the revolution table 5A belonging to the first group and the revolution table 5B belonging to the second group. Furthermore, two gas supply units 9 may be also installed so as to respectively correspond to the revolution table 5A belonging to the first group and the revolution table 5B belonging to the second group. In this case, as in the first embodiment, two gas supply units 9 are disposed so that the center position between these two gas supply units 9 matches the center line 21 (the imaginary plane 22) of the vacuum chamber 2.

As described above, two vacuum exhaust units 3 (3A and 3B) and one gas supply unit 9 are respectively disposed so as to be symmetrical with respect to the center line 21 (the imaginary plane 22) of the plasma CVD apparatus 100. That is, two vacuum exhaust units 3 (3A and 3B) are disposed so that the center position between these two vacuum exhaust units (the vacuum exhaust unit 3A and the vacuum exhaust unit 3B) matches the center line 21 (the imaginary plane 22) of the vacuum chamber 2, and one gas supply unit 9 is disposed so that the center of the gas supply unit 9 matches the center line 21 (the imaginary plane 22) of the vacuum chamber 2. With such an arrangement, a uniform coating process is performed on the substrates W disposed on the two revolution tables 5A and 5B.

The present invention is not limited to the above-described embodiments, and the shapes, the structures, the materials, and the combinations of the respective components may be appropriately modified in the scope without departing from the spirit of the present invention. Further, in the embodiment disclosed herein, the items which are not expressly stated, for example, the running condition, the operation condition, various parameters, the dimensions, the weights, and the volumes of the components, and the like do not limit the normal scope implemented by the person skilled in the art. Then, the items which may be easily supposed by the normal person skilled in the art are employed.

### [Outline of Embodiments]

The above-described embodiments may be summarized as below.

That is, the plasma CVD apparatus according to the above-described embodiments is a plasma CVD apparatus that deposits a coating on each of plural substrates as coating subjects, the plasma CVD apparatus including: a vacuum chamber; a vacuum exhaust unit that evacuates the vacuum chamber so that the inside becomes a vacuum state; a gas supply unit that supplies a source gas into the vacuum chamber; a plasma generation power supply that generates plasma in the source gas supplied into the vacuum chamber; plural rotation holding units that hold the substrates in a spinning state; and plural revolution mechanisms that revolve the plural rotation holding units around a revolution axis parallel to a shaft center and rotation axes of the rotation holding units. Then, the respective revolution mechanisms are divided as any one of a first group connected to one electrode of the plasma generation power supply and a second group connected to the other electrode of the plasma generation power supply.

According to such a configuration, the coating apparatus may perform a stable coating process even when the coating apparatus is used for a long period of time while depositing a coating on plural substrates at one time.
Specifically, the configuration is as below.

According to the above-described configuration, the glow discharge is generated by the potential difference between the revolution table belonging to the first group and the revolution table belonging to the second group, and the source gas becomes plasma due to the glow discharge. In this state, the plural substrates that are held by the rotation holding units revolve about the revolution axis while rotating about the spinning axes of the respective rotation holding units so as to be exposed to the plasma, so that a coating process is uniformly and simultaneously performed on the plural substrates held by the respective rotation holding units.

Further, according to the above-described configuration, the same voltage is applied to the respective revolution tables. For this reason, it is possible to simplify the structure (the voltage supply structure) of the plasma CVD apparatus compared to, for example, a case where a voltage of a different potential is supplied to the respective substrates W disposed on one revolution table.

Further, in the plasma CVD apparatus, it is desirable that the revolution mechanism include the revolution table that is able to revolve about the revolution axis. Then, it is desirable that the respective rotation holding units be disposed at the same interval around the revolution axis with the same radius from the revolution axis of the revolution table.

According to such a configuration, a CVD coating is deposited on the substrates held by the respective rotation holding units disposed in the first substrate holding portion and the second substrate holding portion at a stable condition.

Further, in the plasma CVD apparatus, it is desirable that one revolution mechanism belonging to the first group and one revolution mechanism belonging to the second group be disposed so as to be symmetrical with respect to a center line inside the vacuum chamber, and it is desirable that the vacuum exhaust unit and the gas supply unit be disposed so as to be symmetrical with respect to the center line.

According to such a configuration, a source gas is uniformly supplied to the respective substrates disposed on the pair of revolution tables (the revolution table belonging to the first group and the revolution table belonging to the second group) having opposite polarities. Accordingly, the coating is uniformly deposited on the respective substrates.

### INDUSTRIAL APPLICABILITY

The present invention provides a plasma CVD apparatus.

## Claims

1. A plasma CVD apparatus that deposits a coating on each of a plurality of substrates as coating subjects, the plasma CVD apparatus comprising:
a vacuum chamber;
a vacuum exhaust unit that evacuates the vacuum chamber so that the inside becomes a vacuum state;
a gas supply unit that supplies a source gas into the vacuum chamber;
a plasma generation power supply that generates plasma in the source gas supplied into the vacuum chamber;
a plurality of rotation holding units that hold the substrates in a spinning state; and
a plurality of revolution mechanisms that revolve the plurality of rotation holding units around a revolution axis parallel to rotation axes of the rotation holding units,
wherein the respective revolution mechanisms are divided into any one of a first group connected to one electrode of the plasma generation power supply and a second group connected to the other electrode of the plasma generation power supply.

2. The plasma CVD apparatus according to claim 1,
wherein each revolution mechanism includes a revolution table that is able to revolve about the revolution axis, and
wherein the respective rotation holding units are disposed at the same interval around the revolution axis with the same radius from the revolution axis of the revolution table.

3. The plasma CVD apparatus according to claim 1,
wherein one revolution mechanism belonging to the first group and one revolution mechanism belonging to the second group are disposed so as to be symmetrical with respect to a center line inside the vacuum chamber, and
wherein the vacuum exhaust unit and the gas supply unit are disposed so as to be symmetrical with respect to the center line.
